Europäisches Patentamt

European Patent Office

Office européen des brevets

(19)

(11) Veröffentlichungsnummer: **0 039 080**
**B1**

(12) # EUROPÄISCHE PATENTSCHRIFT

(45) Veröffentlichungstag der Patentschrift:
05.12.84

(21) Anmeldenummer: 81103180.6

(22) Anmeldetag: 28.04.81

(51) Int. Cl.³: **H 03 C 1/02**

(54) **Sender für impulsförmige Hochfrequenzsignale.**

(30) Priorität: 29.04.80 IT 2171580

(43) Veröffentlichungstag der Anmeldung:
04.11.81 Patentblatt 81/44

(45) Bekanntmachung des Hinweises auf die Patenterteilung:
05.12.84 Patentblatt 84/49

(84) Benannte Vertragsstaaten:
DE FR GB NL

(56) Entgegenhaltungen:
DE - A - 3 034 950
DE - B - 2 146 134
DE - B - 2 835 751
GB - A - 2 028 039
US - A - 3 662 290
US - A - 4 088 956

(73) Patentinhaber: **International Standard Electric Corporation, 320 Park Avenue, New York New York 10022 (US)**

(72) Erfinder: **Bertocchi, Giuseppe, Via S. Rocco 58, Vertova (BG) (IT)**

(74) Vertreter: **Graf, Georg Hugo, Dipl.-Ing. et al, c/o Standard Elektrik Lorenz AG Patent- und Lizenzwesen Postfach 300 929 Kurze Strasse 8, D-7000 Stuttgart 30 (DE)**

### Beschreibung

Die Erfindung geht aus von einem Sender wie im Oberbegriff des Patentanspruchs angegeben. Ein solcher Sender ist aus der DE-B-2 835 751 bekannt.

Es ist bekannt, dass Systeme, von denen impulsförmige Signale abgestrahlt werden und bei denen die Information in der Impulslage oder in der Impulsform enthalten ist, weit verbreitet sind. Bei einigen dieser Systeme hängt die Wirksamkeit und die Genauigkeit ganz wesentlich von der Stabilität der abgestrahlten Impulse ab, und davon, wie genau die Form der abgestrahlten Impulse eingehalten werden kann.

Dem Fachmann ist bekannt, dass sich die Charakteristika der Ausgangsimpulse verändern, und zwar bedingt durch Umgebungsbedingungen und durch Betriebsbedingungen. Diese Änderungen, die um so grösser sind, je komplexer das Gerät und das System sind, verschlechtern die Qualitätseigenschaften eines solchen Systemes.

In der genannten Auslegeschrift wird das Modulationssignal aus mehreren in einem Speicher gespeicherten Amplitudenwerten, deren Einhüllende das Modulationssignal ist, aufgebaut. Bei der Regelung werden die gespeicherten Amplitudenwerte so verändert, dass der Sender stets das geforderte impulsförmige Signal abgibt.

Aufgabe der Erfindung ist es, einen Sender mit einer Regeleinrichtung für das Modulationssignal anzugeben, der für Modulationssignale, die nicht aus einer Vielzahl von gespeicherten Amplitudenwerten aufgebaut sind, geeignet ist.

Diese Aufgabe wird bei einem Sender der eingangs genannten Art durch die im Patentanspruch angegebenen Mittel gelöst.

Bei dem neuen Sender ist es auf vorteilhafte Weise möglich, die spektralen Eigenschaften der abgestrahlten Impulse bei optimalen Werten zu halten. Die Impulsdauer der durch die Modulation erzeugten Impulse kann bei Amplituden bei vorgegebenen Prozentsätzen der Maximalamplitude eines Impulses stabil gehalten werden. Durch die neue Regelung des impulsförmigen Modulationssignals ist es möglich, die Impulsvorderflanke stabil zu halten, woraus sich eine bessere Genauigkeit der Messung der Zeitdifferenz zwischen abgestrahltem und empfangenem Impuls bei Sende/Empfangssystemen wie z.B. DME oder TACAN ergibt.

Zu jeder Zeit und unter jeder Betriebsbedingung ist die maximal mögliche Ausgangsleistung des Senders erreichbar. Die Regelung erfolgt so, dass sie streng abhängig ist von den Impulsbreiten. Die Pegel der impulsförmigen Modulationssignale werden geregelt mittels Regelspannungen und Regelströmen, die unabhängig sind von den Pegeln der erzeugten Impulse oder der Impulsfolgefrequenz. Durch die Regelspannungen oder Regelströme werden die Impulsbreiten der demodulierten Ausgangsimpulse auf die vorgeschriebenen Werte gebracht. Diese Werte entsprechen den Sollwerten.

Die Erfindung wird anhand der Zeichnungen beispielsweise näher erläutert. Es zeigt:

Fig. 1 ein Blockschaltbild zur Erläuterung der Erzeugung eines impulsförmigen Modulationssignals,

Fig. 2 ein Blockschaltbild zur Erläuterung des neuen Regelverfahrens,

Fig. 3 ein Blockschaltbild der verwendeten Regelschaltung,

Fig. 4 die in der Regelschaltung gemäss Fig. 3 angewandte Übertragungsfunktion, und

Fig. 5 eine genauere Darstellung der Regelschaltung gemäss Fig. 2.

Die neue Regeleinrichtung für die Impulsmodulation wird anhand eines speziellen Sendesystems, nämlich dem Entfernungsmesssystem DME (oder dem Entfernungsmessteil des TACAN-Systems) erläutert.

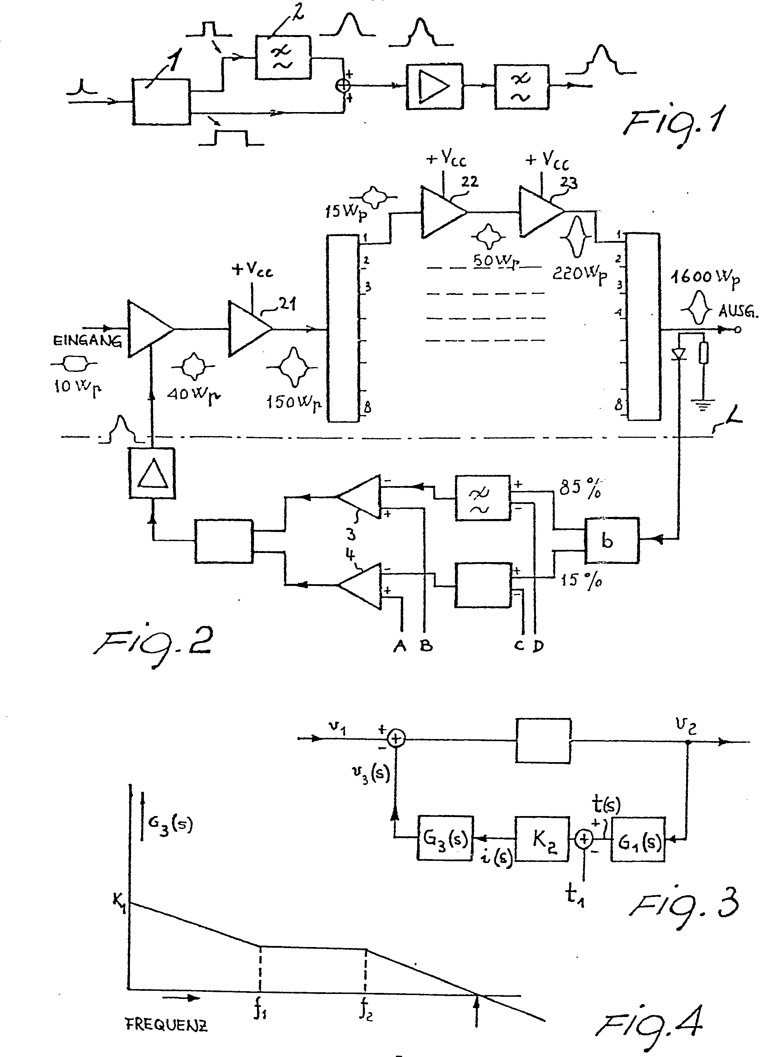

Es ist bekannt, dass von DME-Sendeeinrichtungen Gauss-förmige Impulse abgestrahlt werden. Gauss-förmige Impulse benötigen für eine bestimmte Impulsenergie einen minimalen Spektrumsbedarf. Gauss-förmige Impulse haben ein kompaktes Spektrum. Der Modulationsimpuls besteht aus einem videofrequenten Gauss-förmigen Impuls, der einem breiteren Impuls (Sockelimpuls) überlagert ist (Fig. 1). Dies geschieht aus folgenden Gründen:

1. Man erreicht einen Bereich, in dem die Modulation linear oder quasilinear wird und in dem ein bestimmtes An/Aus-Verhältnis gewährleistet ist,

2. am Ausgang der Modulationsstufe erhält man ein HF-Signal, das eine solche Leistung und eine solche Form hat, dass die Schwellwerte der nachfolgenden drei in Kaskade geschalteten Verstärker 21, 22, 23 überschritten werden,

3. Die Pegel der HF-Eingangssignale für die drei in Kaskade geschalteten Verstärker, in denen keine Modulation erfolgt, bleiben so, dass die Verstärkung in diesen Stufen im C-Betrieb konstant oder quasikonstant bleibt im Bereich, in dem der Impuls dem Sockelimpuls überlagert ist, und dass die Sättigung der Stufe mit der höheren Leistung beginnt.

Diese Bedingungen bleiben jedoch nicht konstant, da sich die Betriebsbedingungen des Senders, z.B. Temperatur, Trägerfrequenz und anderes, ändern.

Die neue Modulationsregeleinrichtung ist in der Lage, langsame Änderungen über einige 10 ms zu kompensieren. Der Pegel des rechteckigen Pilotimpulses des Sockelimpulses wird automatisch geregelt, und zwar so, dass er 5 µs breit ist bei ungefähr 15% des Pegels des demodulierten Ausgangssignals. Gleichzeitig wird der Pegel des rechteckigen Pilotimpulses des Gauss-förmigen Impulses so geregelt, dass der 2 µs breit ist bei ungefähr 85% des Pegels des demodulierten Ausgangsimpulses.

Auf diese Weise wird die Form des Sendeimpulses automatisch geregelt und man erzielt folgende Vorteile:

a) Die spektralen Eigenschaften bleiben erhalten,

b) die Vorderflanke des Impulses bleibt stabil und hat somit eine Verbesserung der Genauigkeit der Zeitmessung zwischen einem Sendeimpuls und einem empfangenen Impuls zur Folge,

c) es wird möglich, zu jedem Zeitpunkt und bei jeder Betriebsbedingung die maximale Ausgangsleistung des Senders auszunützen.

Nachfolgend wird auf die Fig. 1 Bezug genommen. Dem neuen Sender liegt das Prinzip zugrunde, dass das Modulationssignal aus zwei oder mehreren geeignet geformten Komponenten (z.B. den beiden dargestellten rechteckförmigen Signalen unterschiedlicher Dauer, die dann geeignet gefiltert (2) werden) besteht. Die beiden Komponenten werden in einer logischen Schaltung 1 erzeugt, und zwar auf an sich bekannter Weise. Bei dem neuen Sender mit der Modulationseinrichtung, von dem die für die Erfindung wesentlichen Teile beschrieben werden, ist der Pegel der Komponenten, die das Modulationssignal bilden, definiert und geregelt, bevor sie gefiltert und zueinander addiert werden. Die Festlegung des Pegels erfolgt durch Regelspannungen oder Regelströme, und zwar für jede Komponente getrennt. Es ist von Vorteil, dass die Regelspannungen oder die Regelströme vollkommen unabhängig sind von dem absoluten Wert des Pegels des domodulierten Ausgangssignals und von der Anzahl der Impulse pro Zeiteinheit oder dem Tastverhältnis. Sie sind nur abhängig von den Impulsbreiten.

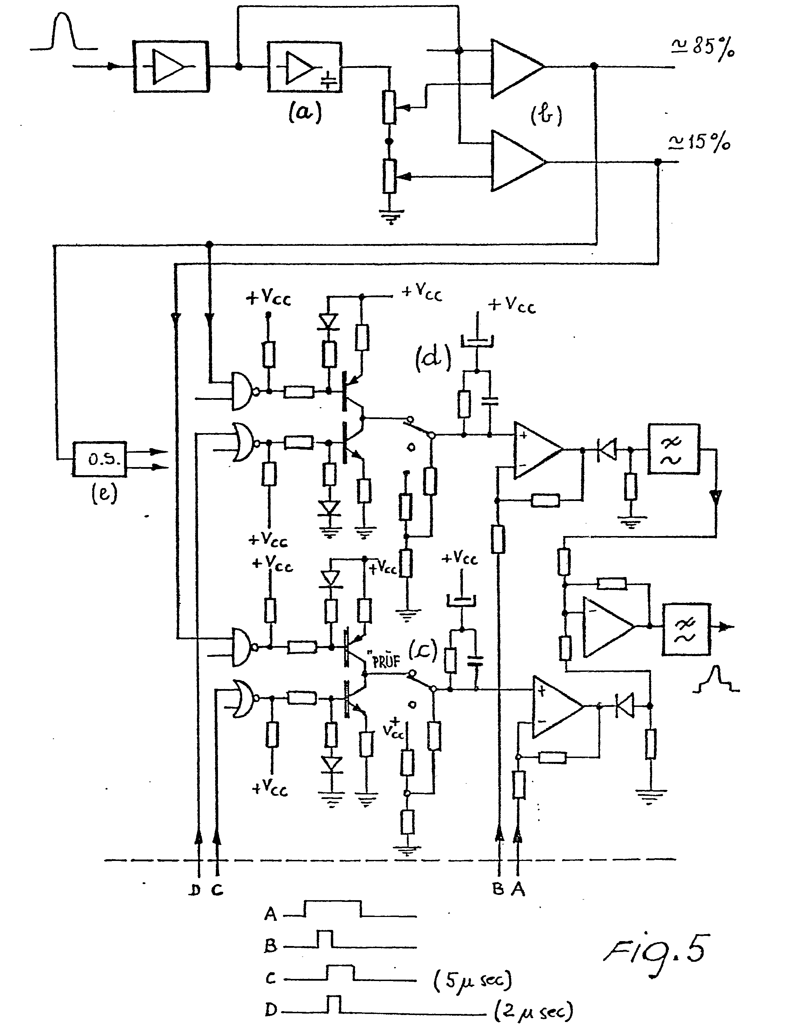

In der Fig. 3 ist die geschlossene Regelschleife zur Regelung einer einzelnen Komponente des aus mehreren Komponenten zusammengesetzten Modulationssignals dargestellt. Es ist:

- $V_1$     das fest vorgegebene Pilotsignal,
- $V_2$     das gleichgerichtete Signal,
- t(s)    die ermittelte Impulsbreite,
- $t_1$     eine Referenzbreite oder Referenzzeit,
- i(s)    der sogenannte «Ladestrom»,
- $V_3(s)$   die Regelspannung,
- G1(s)  der Impulsbreitendetektor, und
- G3(s)  die Lade/Entladeschaltung, die durch ihre Übertragungsfunktion die Systemstabilität als Funktion der Frequenz gewährleistet.

In der Fig. 4 ist die Variation der Übertragungsfunktion von G3(s) als Funktion der Frequenz aufgetragen. Die Kennlinie bleibt zwischen den beiden Frequenzen f1 und f2 konstant.

In der Fig. 5 sind für die neue Regeleinrichtungen genauere Einzelheiten dargestellt. Sie ist eine Kombination aus einem Blockschaltbild und einem Schaltbild. Es erfolgt eine Spitzengleichrichtung für den demodulierten Ausgangsimpuls im Block (a) und das resultierende Signal wird zu zwei Vergleichern (b) geführt wird, die die entsprechenden Impulsbreiten ermitteln.

Der Fachmann entnimmt der Fig. 5, dass es möglich ist, die Impulsbreite unabhängig von den Signalpegeln zu bestimmen. Dies ist eine wesentliche Voraussetzung für den Betrieb, bei dem mehrere Module zur Erhöhung der Ausfallsicherheit parallel geschaltet sind, da sich zwar in diesen Fällen der Signalpegel ändern darf, die Impulsdauer jedoch konstant bleiben muss.

Zwei Schaltungen c und d enthalten Kapazitäten, die aufgeladen und entladen werden. Das Entladen erfolgt im Falle des gewählten DME-Senders während der Zeiten, die gleich den ermittelten Impulsbreiten sind. Die Impulsbreiten wurden, wie bereits erwähnt, bei 15% und 85% des maximalen Pegels ermittelt. Das Laden der Kapazitäten hingegen erfolgt während Zeiten, die gleich den Längen der Referenzimpulse sind; in diesem Fall 5 µs und 2 µs. Den Buchstaben A, B, C, D sind in der Fig. 5, wie auch in der Fig. 2, folgende Bedeutungen zugeordnet:

A Steuerimpuls für den sockelförmigen Teil des Modulationssignals,

B Steuerimpuls für den Gauss-förmigen Teil des Modulationssignals,

C Bezugsimpuls (5 µs Dauer) für den sockelförmigen Teil des Modulationssignals,

D Bezugsimpuls (2 µs Dauer) für den Gauss-förmigen Teil des Modulationssignals.

Diese Signale werden von einem Rechteckimpulsgenerator in Videofrequenzlage erzeugt. Dieser Generator ist allgemein bekannt und wird hier deshalb nicht näher erläutert.

Die von den beiden Schaltungen c, d erzeugten Spannungen modifizieren über Operationsverstärker 3 und 4 den Pegel des Steuerimpulses für den Sockelimpuls und den Pegel des Steuerimpulses für den Gauss-förmigen Impulsteil. Die Regelschaltung wird wirksam geschaltet, wenn das demodulierte Signal über ein Monoflop (e) die NAND- und NOR-Torschaltungen aktiviert.

In der Fig. 2 ist unterhalb der gestrichelten Linie L die Regeleinrichtung funktionell verbunden mit einem bekannten DME-Sender schematisch dargestellt. Wie bereits erwähnt und dargestellt, wird der rechteckige Pilotimpuls für den Pegel des Sockelimpulses automatisch so geregelt, dass eine konstante 5 µs Breite bei ungefähr 15% des demodulierten Ausgangsimpulses bestehen bleibt, und gleichzeitig wird der rechteckige Pilotimpuls für den Pegel des Gauss-förmigen Impulses automatisch so geregelt, dass eine 2 µs Impulsbreite bei ungefähr 85% des demodulierten Ausgangsimpulses erzeugt wird.

Mit der neuen Regeleinrichtung wird das Modulationssignal für einen Sender oder eine andere HF-Einrichtung automatisch so modifiziert, dass beim demodulierten Ausgangssignal stets bei vorgegebenen Prozentsätzen des Pegels die Impulsbreite konstant bleibt. Das Modulationssignal wurde gebildet durch die Kombination von zwei oder mehr Komponenten, die geeignet geformt und anschliessend gefiltert wurden. Bei der neuen Regeleinrichtung werden die Pegel dieser Komponenten eingestellt und geregelt bevor die Addition und Filterung erfolgt. Für jede Komponente ist jeweils ein einziges Regelsignal (Regelspannung oder Regelstrom) vorgesehen.

Solche Regelsignale sind vollkommen unabhängig von dem absoluten Wert des Pegels des Ausgangssignals und von der Anzahl der Impulse pro Zeit. Die Regelung hängt nur von den jeweiligen Impulslängen ab.

Die neue Regeleinrichtung enthält eine Impuls-

breitenbestimmungsschaltung, die unabhängig vom Signalpegel arbeitet, aktive Schaltungen, die, wie bereits erläutert, eine Spannung erzeugen, die unabhängig ist von der Anzahl der Impulse und die nur von der Impulsbreite abhängt, und Verstärkerschaltungen, die die Impulspegel, geregelt durch eine geeignete Spannung oder einen Strom, regeln.

Bei der Beschreibung wurde auf zwei Zeitparameter des Impulses Bezug genommen. Es ist natürlich auch möglich, mehrere Impulsbreiten zur Regelung mit heranzuziehen. So ist es beispielsweise möglich, die Schaltung so auszulegen, dass eine Impulsbreitenbestimmungsschaltung mit N Ausgängen vorgesehen ist. In diesem Fall sind N aktive Schaltungen und N Verstärker notwendig, die jeweils durch eine Spannung (oder einen Strom) geregelt werden. Der Fachmann kann die Schaltung leicht entsprechend ausgestalten.

## Patentansprüche

1. Sender für impulsförmige Hochfrequenzsignale mit einer Hochfrequenzquelle, Verstärkern und eine Modulationseinrichtung zur Erzeugung von impulsförmigen Signalen, bei dem in einer Regeleinrichtung ein Teil des modulierten Verstärkerausgangssignals ausgekoppelt, gleichgerichtet und mit dem Soll-Modulationssignal verglichen wird und entsprechend dem Vergleichsergebnis das tatsächliche Modulationssignal so vorverzerrt wird, dass das Verstärkerausgangssignal den gewünschten Verlauf hat, dadurch gekennzeichnet, dass das Modulationssignal aus einem ersten rechteckförmigen Sockelsignal und einem diesem überlagerten gaussförmigen Signal, das aus einem zweiten rechteckförmigen Signal durch Filterung erzeugt wird, zusammengesetzt ist, dass in der Regeleinrichtung weitere rechteckförmige Signale erzeugt werden, deren Breiten die Breite des ausgekoppelten und gleichgerichteten Verstärkerausgangssignals an zwei Stellen sind, die dadurch festgelegt sind, dass hier die Amplituden des ausgekoppelten Signals jeweils einen vorgegebenen Prozentsatz der Maximalamplitude aufweisen, dass zur Regelung des ersten und des zweiten rechteckförmigen Signals Schaltungen, die eine Kapazität enthalten, vorgesehen sind, dass die Kapazitäten während der Zeiten, während derer die in der Regeleinrichtung erzeugten Signale vorhanden sind, entladen und während der Zeiten, während derer Referenzsignale mit den Sollwerten der Breiten der weiteren rechteckförmigen Signale vorhanden sind, aufgeladen werden, und dass die Ausgangssignale der beiden Schaltungen als Regelsignale zwei Differenzverstärkern (3, 4) zugeführt werden, die als jeweils weiteres Eingangssignal das erste und das zweite Rechtecksignal erhalten.

## Claims

1. Transmitter for pulse-shaped radio-frequency signals with a radio-frequency source, amplifiers and a modulation device for generating pulse-shaped signals, in which, in a control device, part of the modulated amplifier output signal is decoupled, rectified and compared with the nominal modulation signal and, corresponding to the result of the comparison, the actual modulation signal is pre-emphasised in such a way that the amplifier output signal has the desired shape, characterised in that the modulation signal is composed of a first rectangular pedestal signal and a gaussian signal superimposed thereon which is generated by filtering from a second rectangular signal, that, in the control device, further rectangular signals are generated whose widths are the width of the decoupled and rectified amplifier output signal at two places which are determined by the fact that the amplitudes of the decoupled signal represent at each a prescribed percentage of the maximum amplitude, that circuits which contain a capacitor are provided for controlling the first and the second rectangular signal, that the capacitors discharge during the times during which the signals generated in the control device are present and are charged during the times during which reference signals with the nominal values of the further rectangular signals are present, and that the output signals of the two circuits are passed as control signals to two differential amplifiers (3, 4) which receive the first and the second rectangular signal as a further input signal in each case.

## Revendications

1. Emetteur pour signaux impulsionnels à haute fréquence, comportant une source de haute fréquence, des amplificateurs et un dispositif de modulation pour produire des signaux impulsionnels, et dans lequel, dans un dispositif de régulation, une partie du signal de sortie modulé des amplificateurs est redressée et comparée au signal de consigne de modulation et le signal de modulation effectif est préaccentué, en fonction du résultat de la comparaison, de façon que le signal de sortie des amplificateurs ait le profil désiré, caractérisé en ce que le signal de modulation est composé d'un premier signal-socle rectangulaire et d'un signal à forme gaussienne superposé à celui-ci et produit, par filtrage, à partir d'un deuxième signal rectangulaire, en ce que sont produits, dans le dispositif de régulation, d'autres signaux rectangulaires dont les largeurs sont la largeur que le signal de sortie des amplificateurs, capté et redressé, présente en deux endroits qui sont fixés par le fait que les amplitudes du signal capté y ont, en chacun d'eux, un pourcentage de l'amplitude maximale déterminé, en ce que, pour la régulation du premier et du deuxième signal rectangulaire, il est prévu des circuits contenant une capacité, en ce que les capacités sont déchargées pendant les temps au cours desquels les signaux engendrés dans le dispositif de régulation sont présents, et chargées pendant les temps au cours desquels des signaux de référence ayant les valeurs de consigne des largeurs lesdits autres signaux rectangulaires sont présents, et en ce que les signaux de sortie des deux circuits sont amenés, en tant que signaux de réglage, à deux amplificateurs de différence (3, 4) qui reçoivent, en tant que chaque autre signal d'entrée, le premier et le deuxième signal rectangulaire.

Fig.1

Fig.2

Fig.3

Fig.4

$\simeq 85\%$

$\simeq 15\%$

(a)

(b)

(d)

(e)

(c)

"PRÜF

+V$_{cc}$

O.S.

D C

B A

A

B

C ────── (5 μ sec)

D ────── (2 μ sec)

Fig. 5

9